Europäisches Patentamt

European Patent Office

Office européen des brevets

(19)

(11) **EP 0 715 402 A1**

(12) **EUROPEAN PATENT APPLICATION**

(43) Date of publication:
05.06.1996 Bulletin 1996/23

(51) Int. Cl.⁶: **H03D 7/12**

(21) Application number: **95118717.8**

(22) Date of filing: **28.11.1995**

(84) Designated Contracting States:
**DE FR GB**

(30) Priority: **29.11.1994 JP 294416/94**

(71) Applicant: **NEC CORPORATION**
**Tokyo (JP)**

(72) Inventor: **Kamase, Fumihiro,**
**c/o NEC Corp.**
**Minato-ku, Tokyo (JP)**

(74) Representative: **Betten & Resch**
**Reichenbachstrasse 19**
**80469 München (DE)**

(54) **Frequency mixing circuit having a low signal leakage between input signal paths**

(57)     A frequency mixing circuit comprises a pair of first and second transistors connected parallel with each other and receiving RF signal having frequency f1 and LO signal having frequency f2, respectively. The transistor pair supplies a third signal representing a sum of of the first signal and the second signal to a third transistor, which amplifies the third signal in a non-linear amplification to generate a fourth signal. A low pass filter passes the lower frequency component having a frequency f1-f2 in the fourth signal to thereby output an IF signal. The mixing circuit can be used in a portable telephone system and achieves a small dimension thereof and a small signal leakage between input signal paths.

## FIG. 5

EP 0 715 402 A1

## Description

BACKGROUND OF THE INVENTION

(a) Field of the Invention:

The present invention relates to a frequency mixing circuit having a low signal leakage between input signal paths and, more particularly, to an analog mixing circuit for mixing frequencies of a radio frequency (RF) signal and a local oscillation (LO) signal with a low leakage between the signal paths thereof.

(b) Description of Related Art:

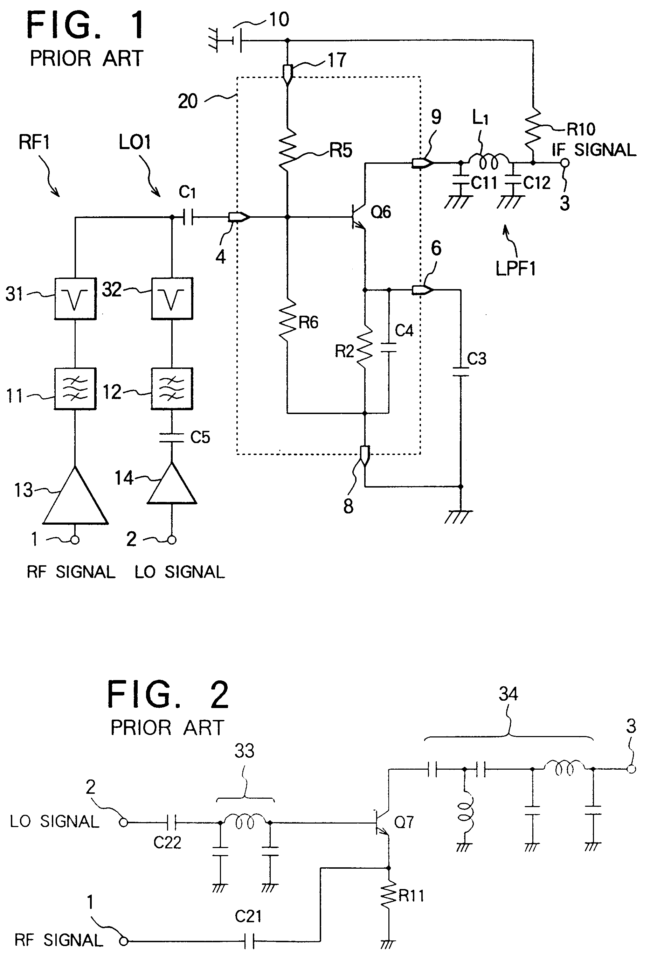

A frequency mixing circuit (simply referred to as mixing circuit hereinafter) is used in a radio communication system, such as portable telephone system, to mix frequencies of a radio frequency (RF) signal and a local oscillation (LO) signal to generate an intermediate frequency (IF) signal. For example, the RF signal has a frequency of 890 MHz while the LO signal has a frequency of 800 MHz, resulting in 90 MHz of the IF signal. A first conventional mixing circuit is shown in Fig. 1, which comprises a mixer IC 20, a RF signal input section RF1, a LO signal input section LO1 both for supplying respective input signals to mixer IC 20, and a low-pass filter LPF1 through which the output of mixer IC 20 is supplied as the output signal of the mixing circuit. The RF signal input section RF1 includes RF amplifier 13, band-pass filter (BPF) 11 and band-elimination filter (BEF) 31, while the LO signal input section LO1 includes LO buffer 14, capacitor C5, BPF 12 and BEF 32. Mixer IC 20 includes NPN transistor Q6, wherein the collector and base of transistor Q6 are connected to output terminal 9 and input terminal 4 of mixer IC 20, respectively, while the emitter of transistor Q6 is connected to the ground through emitter terminal 6 of mixer IC 20 and capacitor C3 and through a resistor R2 and capacitor C4 connected parallel to each other and ground terminal 8 of mixer IC 20. Resistors R5 and R6 are connected in series between power supply lines to thereby bias the base of transistor Q6.

In operation, a RF signal is amplified by RF amplifier 13 and passes through BPF 11 in which undesirable signal components in the RF signal are removed. A LO signal is supplied to BPF 12 via coupling capacitor C5 and LO buffer 14 by which possible, disturbing signals in the LO signal having frequencies close to the frequency of the LO signal are removed. BEFs 31 and 32 are provided to eliminate a first frequency band including the frequency of the LO signal and a second frequency band including the frequency of the RF signal, respectively. By providing the BEFs 31 and 32, the LO signal path acts as an open circuit for the RF signal due to the presence of BEF 32, while the RF signal path acts as an open circuit for the LO signal due to the presence of BEF 31. With this structure, the RF signal and the LO signal are superposed or added together, without causing signal leakage between the two signal paths.

The added signal is then supplied to input terminal 4 of mixer IC 20 via coupling capacitor C1. The added signal undergoes non-linear amplification effected by transistor Q6 in mixer IC 20. The amplified signal is then supplied through output terminal 9 to the low-pass filter LPF1 constituted by L1, C11 and C12. Only the lowest frequency component of the amplified signal, i.e., an IF signal having a frequency of $f1-f2=90$ MHz passes through the LPF1 and is supplied through output terminal 3 of the mixing circuit.

In addition to the mixing circuit as described above, other types of mixing circuits which include no BEF have also been proposed in the prior art.

Fig. 2 shows a second conventional mixing circuit, which include no BEF therein and disclosed in Patent Publication No. JP-A-60(1985)-3234. In this mixing circuit, a RF signal is supplied through RF input terminal 1 to the emitter of transistor Q7 via coupling capacitor C21, while a LO signal is supplied through LO input terminal 2 to the base of transistor Q7 via capacitor C22 and low-pass filter 33. The output from the collector of transistor Q7 is supplied through IF output terminal 3 via low-pass filter 34.

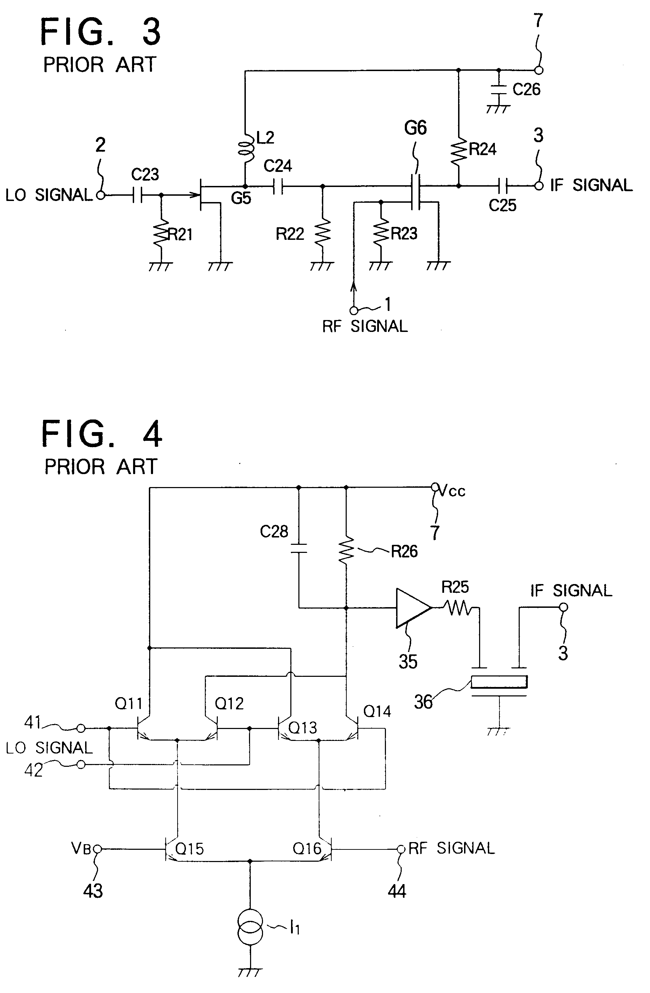

Fig. 3 shows a third conventional mixing circuit, which includes no BEF therein and disclosed in Patent Publication No. JP-A-59(1984)-19439. In this mixing circuit, a LO signal is supplied through LO input terminal 2 to FET G5, and the output signal from the drain of FET G5 is supplied to one of the gates of dual gate FET G6. A RF signal is supplied through RF input terminal 1 to the other gate of dual gate FET G6. An IF signal is output from the drain of FET G6 through output terminal 3.

Fig. 4 shows a fourth conventional mixing circuit, which includes no BEF therein and disclosed in Patent Publication No. JP-A-59(1984)-191907. This mixing circuit is composed of a Gilbert multiplier in which differential circuits are cascaded in a stacked configuration. A RF signal, having a frequency f1 and amplified by a first stage differential transistor pair Q15 and Q16, is mixed with a LO signal having a frequency f2 and amplified by second stage differential transistor pairs Q11, Q12; and Q13, Q14. The mixed signal having a frequency of (f1 - f2) is output from the stacked differential transistor pairs Q11 through Q16 through buffer 35 and solid resonator 36 to output terminal 3.

The first through fourth conventional mixing circuits have respective disadvantages, which will be described later, in the dimension or signal characteristics thereof.

SUMMARY OF THE INVENTION

It is an object of the present invention to provide an improved mixing circuit having a small dimension and improved signal characteristics.

According to the present invention, a frequency mixing circuit is provided which comprises a first and a second transistors having current paths connected parallel with each other and control electrodes for receiving a first signal and a second signal, respectively, the first and second transistors supplying at one of nodes of the current paths a third signal representing an addition of the first signal and second signal, a third transistor for amplifying the third signal in a non-linear amplification to generate a fourth signal, and a filter for passing at least one specified component of the fourth signal.

In a preferred embodiment, the mixing circuit according to the present invention generates an intermediate frequency signal from a RF signal and a LO signal. The mixing circuit comprises band pass filters which allow the RF signal and LO signal having predetermined frequencies to pass therethrough, and a mixer IC for generating an IF signal corresponding to the difference between the frequencies of the RF signal and the LO signal. The mixer IC comprises first and second transistors each having a grounded emitter. The base of the first transistor is connected to input terminal for the RF signal while the base of the second transistor is connected to input terminal for the LO signal of the mixer IC.

The mixer IC further comprises a first resistor connected to the collectors of the first and second transistors and a power supply terminal, first and second bias circuits for biasing the respective bases of the first and second transistors, a third transistor which has a base connected to the collectors of the first and second transistors and a collector for outputting the intermediate frequency signal having a frequency representing the difference between the frequencies of the RF signal and LO signal, a second resistor connected to the emitter of the third transistor and ground terminal, and a first capacitor connected parallel with the second resistor.

In the embodiment, the each bias circuit may comprise a fourth transistor and a third resistor. The emitter of the fourth transistor is grounded while the collector and base of the fourth transistor are connected together to the base of the first or second transistor. The third resistor is connected to the base of the fourth transistor and to the power supply terminal.

In the embodiment, each of the first and second transistors may be composed of a FET instead of the bipolar transistors.

In accordance with the present invention, since band elimination filters (BEFs) can be omitted by the configuration for separating RF input terminal and LO input terminal of the mixer IC, the area for the mixing circuit can be decreased. In addition, it is possible to eliminate losses due to BEFs which would otherwise occur in the signal paths for RF and LO signals.

BRIEF DESCRIPTION OF THE DRAWINGS

The above and other objects, features and advantages of the present invention will be more apparent from the following description, referring to the accompanying drawings in which:

Fig. 1 is a circuit diagram showing a first conventional mixing circuit;
Fig. 2 is a circuit diagram showing a second conventional mixing circuit;
Fig. 3 is a circuit diagram showing a third conventional mixing circuit;
Fig. 4 is a circuit diagram showing a fourth conventional mixing circuit;
Fig. 5 is a circuit diagram showing a mixing circuit according to a first embodiment of the present invention;
Fig. 6 is a circuit diagram showing the mixer IC in Fig. 5, including an example of the configuration of the bias sections in Fig. 5; and
Fig. 7 is a circuit diagram showing a mixing circuit according to a second embodiment of the present invention.

DESCRIPTION OF THE PREFERRED EMBODIMENTS

Before describing embodiments of the present invention, respective disadvantages of the conventional mixing circuits will be described for the sake of understanding the advantages of the present invention.

In the mixing circuit shown in Fig. 1, the RF signal and LO signal are supplied to the same input terminal 4 of the mixer IC 20, which requires BEFs 31 and 32 to be inserted into the corresponding signal paths, as shown in the drawing, in order to keep the RF signal path and the LO signal path separated from each other. This results in an increase of the dimension of the mixing circuit.

The mixing circuit shown in Fig. 2 has a problem that the LO signal leaks to the signal path for receiving the RF signal, because RF input terminal 1 is directly connected to the emitter of transistor Q7. In particular, a band elimination filter (BEF) must be provided if the mixing circuit is used in portable telephone systems.

The mixing circuit shown in Fig. 3 is not suitable for use in a high frequency band higher than 800 MHz, for example, because of the presence of dual gate MOS FET G6, which is generally known to have poor frequency characteristics in the higher frequency band.

Mixing circuit shown in Fig. 4 has an advantage that the RF signal and LO signal are kept separated from each other by using a Gilbert multiplier. However, since transistors are arranged in a stacked configuration of three stages, i.e., three serial transistors including constant current sources and connected between the power supply lines, a power source having a lower power supply voltage, e.g., 3.3 volts cannot be employed without malfunction of the transistors.

Now, the present invention will be described with reference to the preferred embodiments.

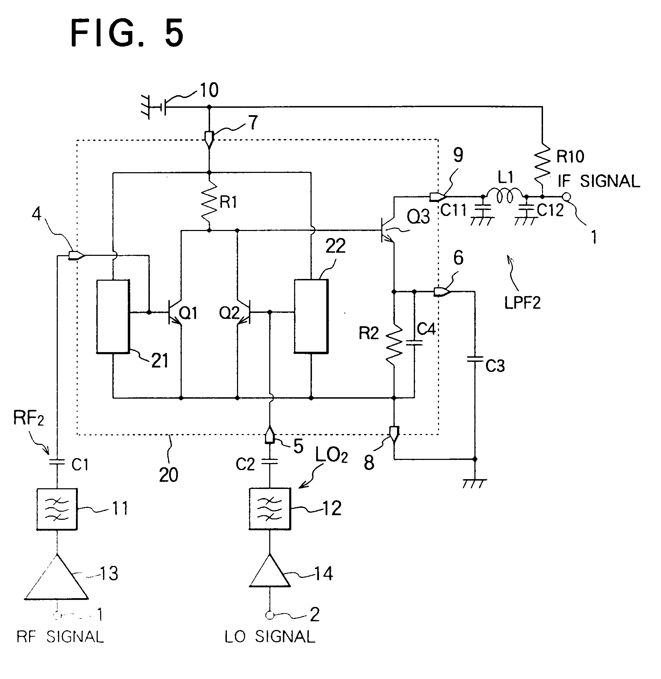

Referring to Fig 5, a mixing circuit according to a first embodiment of the present invention has a mixer IC 20, a RF signal input section RF2, a LO signal input section LO2, and an intermediate frequency signal output section including a low-pass filter LPF2 implemented by capacitors C11 and C12 and inductor L1. The RF signal input section RF2 includes RF amplifier 13, band-pass filter 11 and coupling capacitor C1 cascaded in series, while the LO signal input section LO2 includes LO buffer 14, band-pass filter 12 and coupling capacitor C2 cascaded in series. The output of the RF signal input section RF2 and the output of the LO signal input section LO2 are connected to RF input terminal 4 and LO input terminal 5, respectively, of mixer IC 20. Output terminal 9 of mixer IC 20 is connected to output terminal 3 of the mixing circuit of the present embodiment through the low-pass filter LPF2.

Mixer IC 20 includes three NPN transistors Q1, Q2 and Q3, bias sections 21 and 22 each for the base of each of transistors Q1 and Q2, and output transistor Q3 for non-linear amplification. Transistors Q1 and Q2 form a transistor pair having emitter-collector current paths connected parallel with each other. The collectors of transistors Q1 and Q2 are connected together to power supply source 10 through resistor R1 and power supply terminal 7 of mixer IC 20. The emitters of the transistor pair Q1 and Q2 are connected together to the ground through ground terminal 8. The base of transistor Q1 is connected to RF input terminal 4 of mixer IC 20 while the base of transistor Q2 is connected to LO input terminal 2 of mixer IC 20. The transistor pair Q1 and Q2 constitute an adding section for the RF signal and LO signal.

The base of transistor Q3 is connected to the collector output of the transistor pair Q1 and Q2. The collector output of transistor Q3 is connected to output terminal 3 of the mixing circuit through output terminal 9 of mixer IC 20 and the low-pass filter LPF2. The output terminal 3 of the mixing circuit is connected to the power supply source 10 through pull up resistor R10. The emitter of transistor Q3 is connected to emitter output 6 of mixer IC 20 and also connected to ground terminal 8 of mixer IC 20 through resistor R2 and capacitor C4 connected parallel with each other. Emitter terminal 6 is connected to the ground through capacitor C3 while ground terminal 8 of mixer IC 20 is connected directly to the ground.

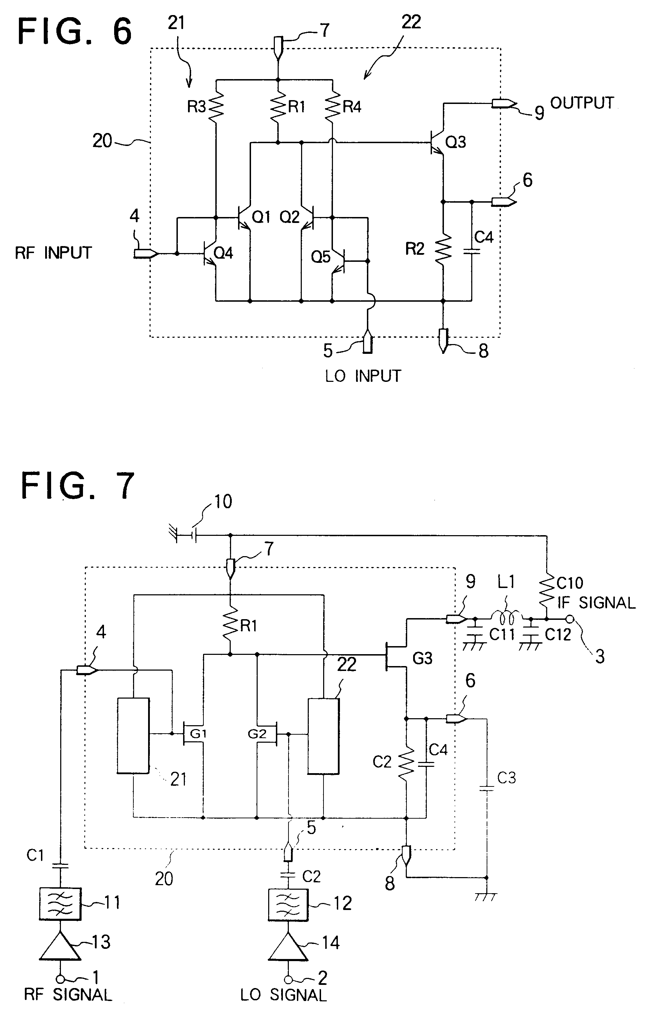

Referring to Fig. 6 which illustrates an example of mixer IC 20 in Fig. 5, an example of bias sections 21 and 22 is schematically shown together with the other elements in the mixer IC 20. The bias section 21 is implemented by transistor Q4 and resistor R3 connected in series between power supply terminal 7 and ground terminal 8, while the bias section 22 is implemented by transistor Q5 and resistor R4 connected in series between power supply terminal 7 and ground terminal 8. The base and collector of transistor Q4 are connected together to RF input terminal 4 of mixer IC 20. The base and collector of transistor Q5 are connected together to LO input terminal 5 of mixer IC 20. RF input terminal 4 is connected to the base of transistor Q1 and to power supply terminal 7 through resistor R3, while LO input terminal 5 is connected to the base of transistor Q2 and to power supply terminal 7 through resistor R4.

In the present embodiment, BEFs are omitted by separately providing RF input terminal 4 and LO input terminal 5 of mixer IC. The RF signal and LO signal thus supplied to mixer IC 20 are mixed at the collectors of the transistor pair Q1 and Q2.

It is assumed that the RF signal $V_{RF}$ has a waveform $\cos\omega_1 t$, and the LO signal $V_{LO}$ has a waveform $\cos\omega_2 t$. The signal $V_1$ supplied to the base of transistor Q3 can be expressed as the sum of the RF signal $V_{RF}$ and the LO signal $V_{LO}$ and is given by the following equation:

$$V_i = V_{RF} + V_{LO} = V_1\cos\omega_1 t + V_2\cos\omega_2 t. \tag{1}$$

The output $V_o$ of transistor Q3 obtained by non-linear amplification thereof is expressed by the following equation:

$$V_o = AV_i + BV_i^2 + CV_i^3. \tag{2}$$

From equations (1) and (2), following equations are obtained:

$$AV_i = A[V_1\cos\omega_1 t + V_2\cos\omega_2 t]$$

$$BV_i^2 = B[V_1^2\cos^2\omega_1 t + V_2^2\cos\omega_2 t + 2V_1 \cdot V_2\cos\omega_1 t \cdot \cos\omega_2 t]$$

$$CV_i^3 = C[V_1^3\cos\omega_1 t + V_2^3\cos\omega_2 t + 3V_1 \cdot V_2\cos\omega_1 t \cdot \cos\omega_2 t(V_1\cos\omega_1 t + V_2\cos\omega_2 t)]$$

The third term of the equation for $BV_i^2$ includes a signal component:

4

$$2V_1 \cdot V_2 \cos\omega_1 t \cdot \cos\omega_2 t = V_1 \cdot V_2[\cos(\omega_1 t + \omega_2 t) + \cos(\omega_1 - \omega_2)t]. \qquad (3)$$

Accordingly, after the output signal $V_o$ is passed through the low-pass filter LPF2 composed of inductor L1 and capacitors C11 and C12, the lower frequency component expressed by

$$V_{IF} = V_1 \cdot V_2 \cos(w_1 - w_2)t$$

is obtained as the output signal of the mixing circuit.

By the structure of the present embodiment, the portion of the mixing circuit which separate the RF signal and the LO signal from each other can be formed as a part of an integrated circuit, without including BEFs such as 31 and 32 in Fig. 1. Assuming that each BEF in Fig. 1 requires an area of 9.0 mm², the area required for mounting the mixing circuit on a printed circuit board can be reduced by 18 mm². Further, assuming that each BEF generates an insertion loss of 1 dB, the losses generated at the RF signal input and the LO signal input can be reduced by 1 dB.

Fig. 7 shows a mixing circuit according to a second embodiment of the present invention, in which FETs G1, G2 and G3 are used in mixer IC 20, instead of the bipolar transistor pair Q1 and Q2 and bipolar transistor Q3 in Fig. 5. Other configurations are similar to those of the mixing circuit of Fig. 5, so that description thereof are omitted here for avoiding a duplication. The mixing circuit according to the second embodiment which utilizes FETs provides advantages similar to those provided by the first embodiment.

Since above embodiments are described only for examples, the present invention is not limited to such embodiments and it will be obvious for those skilled in the art that various modifications or alterations can be easily made based on the above embodiments within the scope of the present invention.

**Claims**

1. A frequency mixing circuit comprising an adding section receiving a first signal and a second signal to generate a third signal representing an addition of said first signal and second signal, and an amplifying section (Q3, R2, C4) for amplifying said third signal in a non-linear amplification, characterized in that:
   said adding section includes a first and a second transistors (Q1, Q2) having current paths connected parallel with each other and control electrodes for receiving said first signal and second signal, respectively, said first and second transistors (Q1, Q2) outputting at one of nodes of said current paths said third signal.

2. A frequency mixing circuit as defined in Claim 1 further comprising a bias section (21, 22) for the control electrode of each of said first and second transistors (Q1, Q2), wherein said bias section (21, 22) includes a fourth transistor (Q4, Q5) and a resistor (R3, R4).

3. A frequency mixing circuit as defined in Claim 1 wherein said first through third transistors (Q1, Q2, Q3) are implemented by bipolar transistors.

4. A frequency mixing circuit as defined in Claim 1 wherein said first through third transistors (G1, G2, G3) are implemented by field effect transistors.

5. A frequency mixing circuit as defined in Claim 1 wherein said first through third transistors (Q1, Q2, Q3; G1, G2, G3) are implemented on a single chip (20) of an integrated circuit.

# FIG. 1
PRIOR ART

RF1   LO1

RF SIGNAL   LO SIGNAL

IF SIGNAL

# FIG. 2
PRIOR ART

LO SIGNAL

RF SIGNAL

# FIG. 3
## PRIOR ART

# FIG. 4
## PRIOR ART

# FIG. 5

# FIG. 6

RF INPUT

LO INPUT

OUTPUT

# FIG. 7

RF SIGNAL

LO SIGNAL

IF SIGNAL

**European Patent Office**

## EUROPEAN SEARCH REPORT

Application Number

EP 95 11 8717

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP-A-0 488 257 (FUJITSU LTD ;FUJITSU VLSI LTD (JP)) 3 June 1992<br>* column 4, line 9 - column 5, line 47 *<br>* column 6, line 8 - column 6, line 23; figures 5,6,8 * | 1,3,5 | H03D7/12 |
| Y | | 2,4 | |
| | --- | | |
| X | US-A-3 609 412 (OKUMURA TOMISABURO) 28 September 1971<br>* column 1, line 25 - column 2, line 35; figure 1 * | 1,3,5 | |
| | --- | | |
| Y | PATENT ABSTRACTS OF JAPAN<br>vol. 007 no. 255 (E-210) ,12 November 1983<br>& JP-A-58 141011 (TOKYO SHIBAURA DENKI KK) 22 August 1983, | 4 | |
| A | * abstract * | 1-3 | |
| | --- | | |
| Y | SEIFART, M. 'Analoge Schaltungen'<br>1987 , VEB VERLAG TECHNIK , BERLIN<br>* page 132, paragraph 6.4.2 - page 137, line 23; figures 6.3-6.7 * | 2 | TECHNICAL FIELDS SEARCHED (Int.Cl.6)<br><br>H03D |
| | ----- | | |

The present search report has been drawn up for all claims

| Place of search | Date of completion of the search | Examiner |
|---|---|---|
| MUNICH | 6 March 1996 | Zwicker, T |

EPO FORM 1503 03.82 (P04C01)